# DEMANDE DE BREVET EUROPEEN

(11) **EP 3 587 907 A1**
(43) Date de publication de la demande: **01.01.2020**
(21) Numéro de dépôt: 19180771.8
(22) Date de dépôt: 18.06.2019
(51) Int. Cl.: F21S 41/675, F21S 45/47, F21S 45/10, G03B 21/16, G02B 26/08, B81B 7/00

(54) **MODULE OPTIQUE COMPRENANT UNE CARTE ÉLECTRONIQUE AVEC UNE PUCE ÉLECTRONIQUE**

(30) Priorité: 25.06.2018 FR 1855662
(71) Demandeur: Valeo Vision, 93012 Bobigny Cedex (FR)
(72) Inventeur: ROUSSEAU, Maxime, 93012 Bobigny Cedex (FR); DANIEL, Thomas, 93012 Bobigny Cedex (FR); CHOQUET, Pierre, 93012 Bobigny Cedex (FR)
(74) Mandataire: Valeo Vision

(57) **Abrégé**

Module optique (3) caractérisé en ce qu'il comprend :
- un boîtier (10),
- une carte électronique (30),
- une puce (20) électronique comprenant une matrice de micro-miroirs (21), la puce (20) étant fixée à la carte électronique (30),
- un organe de dissipation thermique (50) comprenant un dissipateur thermique (51),
la puce (20) étant en contact d'une part contre le boîtier (10) et d'autre part avec le dissipateur thermique (51), l'organe de dissipation thermique (50) étant fixé au boîtier (10) par l'intermédiaire d'un premier volume de colle (41) et fixé à la carte électronique (30) par l'intermédiaire d'un deuxième volume de colle (42).

## Description

### Domaine technique de l'invention

La présente invention concerne un module optique comprenant une carte électronique, notamment une carte électronique comprenant une puce susceptible de s'échauffer telle qu'une puce comprenant une matrice de micro-miroirs. L'invention concerne également un projecteur comprenant un tel module optique. L'invention concerne également un procédé de fabrication d'un tel module optique.

### État de la technique

Pour l'éclairage des véhicules automobiles, on connaît l'utilisation de modules optiques comprenant une source lumineuse et une matrice de micro-miroirs. Une matrice de micro-miroirs est un microsystème électromécanique comprenant une multitude de micro-miroirs qui sont tous mobiles autour d'un même axe et qui peuvent prendre au moins deux orientations distinctes. Selon sa première orientation, un micro-miroir transmet un rayon lumineux hors du module optique, dans un champ d'éclairage. Selon sa deuxième orientation, le rayon lumineux est dévié hors du champ d'éclairage. L'orientation de chaque micro-miroir peut être commandée individuellement par l'effet d'une force électrostatique. Le module optique comprend un circuit de commande relié à une unité de commande électronique. L'unité de commande électronique émet un courant de commande à destination de chacun des micro-miroirs pour définir leur orientation.

De tels modules optiques permettent de composer et de projeter des images complexes devant le véhicule. Ils sont donc utilisés pour réaliser différentes fonctions telles que par exemple la projection d'informations utiles à la sécurité de piétons situés aux abords directs du véhicule, ou encore par exemple une fonction d'éclairage de la route évitant l'éblouissement des autres automobilistes. Par conséquent, le module optique doit comprendre un montage précis pour produire des images nettes et correctement positionnées dans l'espace. Notamment, le positionnement de la puce comprenant la matrice de micro-miroirs doit respecter un positionnement très précis.

Par ailleurs, lors de son fonctionnement, un tel module optique peut s'échauffer fortement. Un échauffement excessif peut conduire à un disfonctionnement, voire à la destruction, de la matrice de micro-miroirs ou de son circuit de commande. Afin de refroidir la matrice de micro-miroirs, on connaît l'utilisation de dissipateurs thermiques. Toutefois, les dissipateurs thermiques n'évacuent pas toujours efficacement la chaleur produite. De plus, on note que l'assemblage des modules optiques existants induit souvent des contraintes néfastes sur la carte électronique, ce qui risque d'entraîner une usure prématurée et un disfonctionnement du module optique.

### Objet de l'invention

Le but de l'invention est de fournir un module optique améliorant les solutions connues de l'art antérieur.

Plus précisément, un objet de l'invention est d'améliorer l'assemblage entre les composants d'un module optique comprenant une carte électronique, une puce comprenant une matrice de micro-miroirs, un dissipateur thermique et un boîtier.

A cet effet, l'invention se rapporte à un module optique comprenant :
- un boîtier,
- une carte électronique,
- une puce électronique comprenant une matrice de micro-miroirs, la puce étant fixée à la carte électronique,
- un organe de dissipation thermique comprenant un dissipateur thermique,
la puce étant en contact d'une part contre le boîtier et d'autre part avec le dissipateur thermique, l'organe de dissipation thermique étant fixé au boîtier par l'intermédiaire d'un premier volume de colle et fixé à la carte électronique par l'intermédiaire d'un deuxième volume de colle.

La carte électronique, l'organe de dissipation thermique et le boîtier peuvent être sans contact direct entre eux.

La puce peut comprendre un moyen de positionnement apte à coopérer avec le boîtier.

La puce peut être fixée à la carte électronique en vis-à-vis d'une ouverture de la carte électronique, la puce comprenant une première face en contact avec le boîtier, la puce comprenant une deuxième face en contact avec le dissipateur thermique, la première face et la deuxième face étant deux faces opposées de la puce.

La carte électronique peut s'étendre selon un plan, l'organe de dissipation thermique peut être fixé au boîtier selon un premier plan de liaison, et l'organe de dissipation thermique peut être fixé à la carte électronique selon un deuxième plan de liaison, le premier plan de liaison, le deuxième plan de liaison et le plan dans lequel s'étend la carte électronique étant sensiblement parallèles entre eux.

L'organe de dissipation thermique peut être monobloc.

L'organe de dissipation thermique et/ou le boîtier et/ou la carte électronique peuvent comprendre une ouverture destinée à laisser passer des rayons lumineux, l'ouverture débouchant dans le premier volume de colle et/ou dans le deuxième volume de colle.

L'organe de dissipation thermique peut comprendre un élément de liaison fabriqué dans un matériau transparent ou translucide lié au dissipateur thermique.

L'organe de dissipation thermique peut comprendre une surface d'échange agencée sur une excroissance, en contact avec la puce, et une première surface de liaison et une deuxième surface de liaison agencées sur des saillies, fixées respectivement au boîtier et à la carte électronique par l'intermédiaire de respectivement les premier et deuxième volumes de colle, la surface d'échange et la première et la deuxième surfaces de liaison étant parallèles.

La colle peut être une colle thermique ou une colle apte à durcir sous l'effet d'un rayonnement lumineux, notamment UV.

L'invention se rapporte également à un projecteur comprenant au moins un module optique tel que décrit précédemment.

L'invention se rapporte également à un procédé de fabrication d'un module optique comprenant :
- une première étape de fixation d'une puce comprenant une matrice de micro-miroirs à une carte électronique,
- une deuxième étape de positionnement d'un boîtier en appui contre la puce,
- une troisième étape d'application d'un premier volume de colle sur une première surface de liaison d'un organe de dissipation thermique ou du boîtier,
- une quatrième étape d'application d'un deuxième volume de colle sur une deuxième surface de liaison de l'organe de dissipation thermique ou de la carte électronique,
- une cinquième étape de positionnement d'un dissipateur thermique de l'organe de dissipation thermique en appui contre la puce, de la première surface de liaison de l'organe de dissipation thermique contre le boitier par l'intermédiaire du premier volume de colle et de la deuxième surface de liaison de l'organe de dissipation thermique contre la carte électronique par l'intermédiaire du deuxième volume de colle,
- une sixième étape de durcissement du premier volume de colle et du deuxième volume de colle.

### Description sommaire des dessins

Ces objets, caractéristiques et avantages de la présente invention seront exposés en détail dans la description suivante de deux modes de réalisation particuliers faits à titre non-limitatif en relation avec les figures jointes parmi lesquelles :
- la figure 1 est une vue schématique d'un véhicule automobile selon un mode de réalisation de l'invention ;
- la figure 2 est une première vue schématique en coupe de coté d'un module optique selon un premier mode de réalisation de l'invention ;
- la figure 3 est une vue schématique en coupe de coté d'une interface entre un organe de dissipation thermique et un boîtier du module optique selon le premier mode de réalisation de l'invention ;
- la figure 4 est une deuxième vue schématique en coupe de coté d'un module optique selon un deuxième mode de réalisation de l'invention ;
- la figure 5 est une vue en perspective partielle de la carte électronique et d'une partie d'une puce selon un mode de réalisation de l'invention ;
- la figure 6 est une vue en perspective partielle de la carte électronique et de la puce selon un mode de réalisation de l'invention.

### Description d'un mode de réalisation

Pour la simplicité de la présentation de ces modes de réalisation, les mêmes références seront utilisées pour les deux modes de réalisation pour désigner des composants identiques ou similaires.

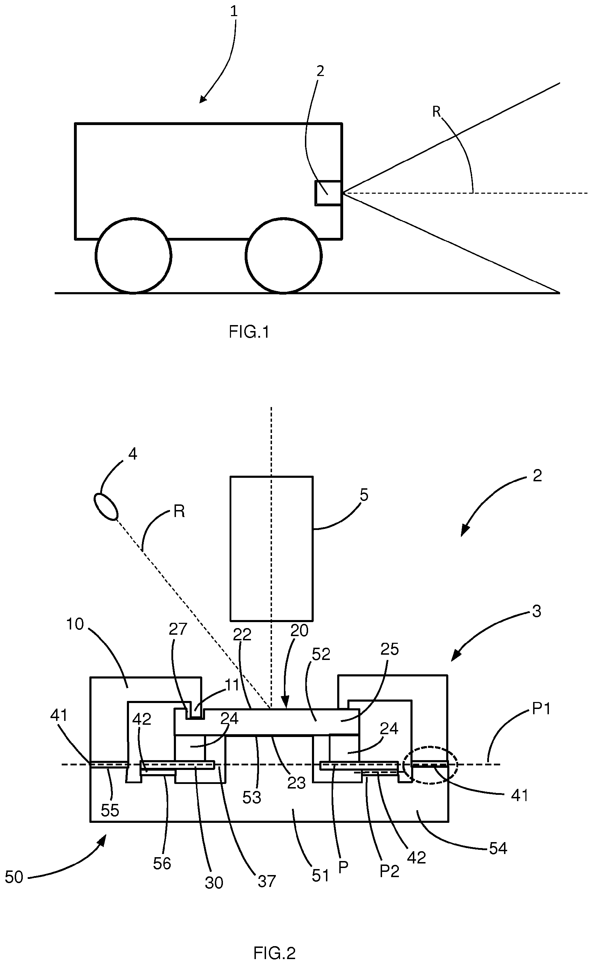

La figure 1 illustre un véhicule 1 automobile muni d'un projecteur 2 selon un mode de réalisation de l'invention. Le véhicule peut être de toute nature, par exemple il peut s'agir d'un véhicule particulier, d'un véhicule utilitaire ou d'un camion. Le projecteur 2 est disposé à l'avant du véhicule mais pourrait aussi bien équiper l'arrière du véhicule. Le projecteur permet d'éclairer la route, d'être vu des autres automobilistes et/ou de projeter sur le sol des images fournissant des informations au conducteur ou à son environnement.

En référence à la figure 2, le projecteur 2 comprend un module optique 3 selon un premier mode de réalisation de l'invention, et notamment au moins une source de lumière 4 et au moins un système optique de projection 5. La source de lumière peut être une diode électroluminescente, une ampoule à incandescence ou toute autre source de lumière équivalente. Le système optique de projection peut être un ensemble d'une ou plusieurs lentilles optiques transparentes, translucides ou réfléchissantes. Le système optique de projection est apte à être traversé par des rayons lumineux R issus de la source de lumière.

Le module optique 3 comprend un boîtier 10, une puce 20 électronique, une carte électronique 30 et un organe de dissipation thermique 50.

Le boîtier 10 est une structure supportant différents éléments du module optique 3. Le boîtier peut notamment supporter la source de lumière 4 et/ou le système optique de projection 5. Le boîtier peut également comprendre un ou plusieurs moyens de fixation pour sa fixation dans le projecteur 2 du véhicule 1. Il peut être fabriqué à partir d'un matériau en plastique, par exemple par injection plastique.

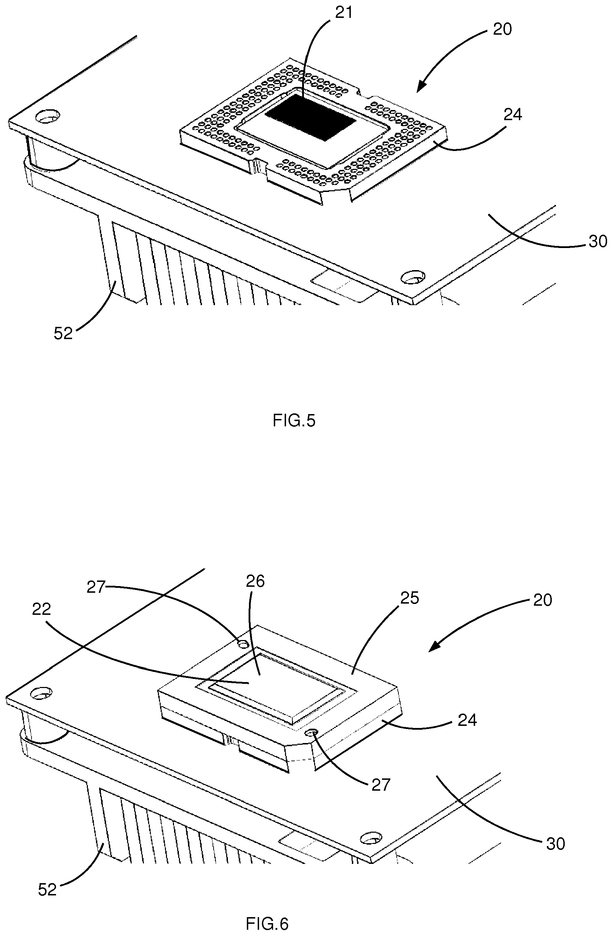

La puce 20, notamment illustrée sur les figures 5 et 6, est un composant électronique, connecté électriquement à la carte électronique 30. La puce 20 comprend une matrice de micro-miroirs 21. La matrice de micro-miroirs 21 est un microsystème électromécanique comprenant une multitude de micro-miroirs plats qui sont tous mobiles indépendamment autour d'un même axe. Chaque micro-miroir peut prendre deux orientations distinctes : une orientation dite « active » et une orientation dite « inactive ». L'orientation de chaque micro-miroir peut être commandée individuellement par l'effet d'une force électrostatique. La matrice de micro-miroirs peut comprendre plusieurs centaines de micro-miroirs sur la largeur et plusieurs centaines de micro-miroirs sur la longueur. La matrice de micro-miroirs 21 est intégrée à la puce 20 de plus grande dimension. La source de lumière est agencée de manière à pouvoir projeter des rayons lumineux sur la matrice de micro-miroirs. Les rayons lumineux réfléchis par des micro-miroirs en orientation active peuvent traverser le système optique de projection pour contribuer utilement à une fonction d'éclairage. Les rayons lumineux réfléchis par des micro-miroirs en orientation inactive sont réfléchis vers une zone non fonctionnelle du projecteur et peuvent être dissipés sous forme de chaleur.

La puce 20 peut avoir une forme globalement rectangulaire. Elle comprend une première face 22, tournée du coté de la source de lumière 4, sur laquelle apparait la matrice de micro-miroirs 21, et une deuxième face 23 (indiquée sur la figure 2), opposée à la première face. La puce 20 comprend en outre une surface de référence 25 s'étendant autour de la matrice de micro-miroirs 21, du coté de la première face 22. La surface de référence n'est pas destinée à réfléchir les rayons lumineux issus de la source lumineuse vers le système optique de projection. La surface de référence 25 est solidaire d'une structure de la puce supportant la matrice de micro-miroirs. Le positionnement de la surface de référence 25 par rapport à la matrice de micro-miroirs est défini lors de la fabrication de la puce. Avantageusement, l'orientation de chaque micro-miroir par rapport à la surface de référence est maitrisée lors de la conception et lors de la fabrication de la puce. La surface de référence 25 comprend une ouverture centrale accueillant la matrice de micro-miroirs 21. Cette ouverture centrale peut être recouverte d'une vitre de protection 26. La surface de référence 25 comprend un moyen de positionnement 27 apte à coopérer avec le boîtier 10 pour obtenir un bon positionnement de la puce 20 par rapport au boîtier 10. Le moyen de positionnement 27 est constitué de deux trous de forme cylindrique positionnés chacun au niveau de deux coins opposés de la surface de référence 25. Ces deux trous sont aptes à coopérer avec des plots 11 correspondant et formant saillie du boîtier 10. La puce 20 est donc en appui directement contre le boîtier 10. La position de la puce 20 est définie directement par le boîtier 10.

La puce 20 est fixée à la carte électronique 30 par l'intermédiaire d'une interface de connexion 24. L'interface de connexion 24, particulièrement visible sur la figure 5, peut comprendre un réceptacle garni d'orifices, également dénommé selon l'anglicisme « socket », et destinés à recevoir des broches de la puce 20. L'interface de connexion à une forme extérieure sensiblement identique à celle de la surface de référence 25. Elle comprend également une ouverture centrale dans laquelle est positionnée la matrice de micro-miroirs 21.

La carte électronique 30 est une carte de circuit imprimé s'étendant selon un plan P. Elle peut avoir une forme globalement rectangulaire. Elle peut comprendre des composants électroniques, outre la puce 20, et des pistes électriques permettant de relier les composants électroniques entre eux. Elle peut également comprendre une connectique permettant de connecter la carte électronique à une unité de commande électronique apte à émettre des ordres de commande pour commander l'orientation de chaque micro-miroir. La carte électronique 30 est sans contact avec le boîtier 10. La position de la carte électronique par rapport au boîtier est définie par la position de la puce 20. La carte électronique 30 comprend également une ouverture 37 en vis-à-vis de l'ouverture centrale de l'interface de connexion 24. Ainsi, la deuxième face 22 de la puce 20 est accessible au travers de l'ouverture 37 pratiquée dans la carte électronique.

L'organe de dissipation thermique 50 comprend un dissipateur thermique 51. Le dissipateur thermique, également dénommé échangeur thermique ou radiateur, est une pièce servant à dissiper l'énergie calorifique générée par la puce 20. Avantageusement il est fabriqué à partir d'un matériau présentant de bonnes propriétés de conduction thermique et comprend une surface d'échange avec l'air importante. A cet effet, le dissipateur thermique peut comprendre des picots ou des ailettes formant saillie dans un volume ou de l'air peur circuler. Le dissipateur thermique 51 comprend une excroissance 52 orientée perpendiculairement au plan P de la carte électronique et passant au travers de l'ouverture 37 de la carte électronique. L'excroissance 52 comprend une surface d'échange 53 en contact plan avec la puce 20 au niveau de sa deuxième face 23. La position du dissipateur thermique 51 est donc définie en référence à la puce 20. L'organe de dissipation thermique 50 est sans contact avec le boîtier 10, et sans contact avec la carte électronique. Ni le boîtier 10, ni le dissipateur thermique 51 ne contraignent la carte électronique 30.

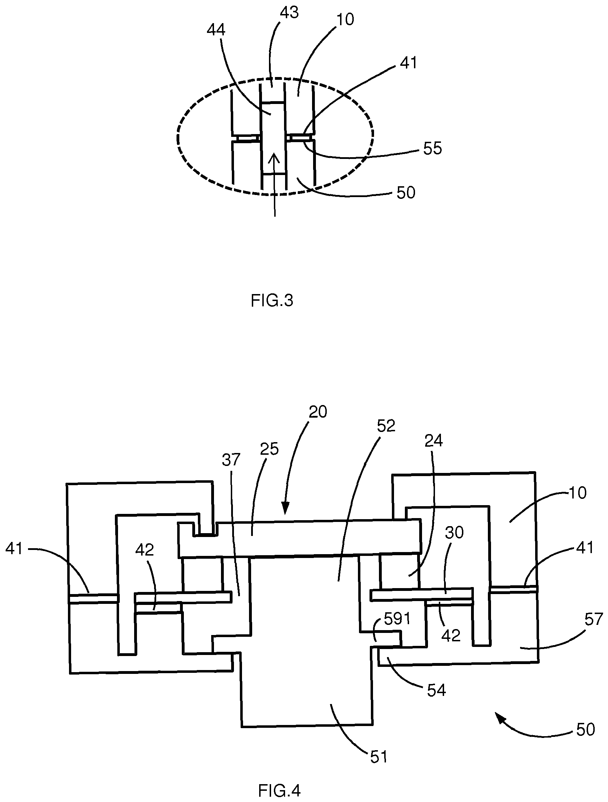

Selon un premier mode de réalisation, illustré sur les figures 2 et 3, l'organe de dissipation thermique 50 est monobloc, c'est-à-dire qu'il est réalisé à partir d'une seule et même pièce. Il comprend une base 54 s'étendant le long de la carte électronique 30, du coté opposé à la face de la carte électronique sur laquelle est fixée la puce 20. Il comprend également une première surface de liaison 55 et une deuxième surface de liaison 56, toutes deux orientées parallèlement au plan P, et formées en surface supérieure de saillies s'étendant depuis la base 54, perpendiculairement au plan P. La première surface de liaison 55 et la deuxième surface de liaison 56 peuvent être des surfaces annulaires centrées autour de l'excroissance 52. En variante, les surfaces de liaison 55, 56 peuvent être constituées chacune d'une ou plusieurs surfaces discontinues agencées autour de l'excroissance 52. La deuxième surface de liaison 56 est positionnée entre la première surface de liaison 55 et l'excroissance 52.

L'organe de dissipation thermique 50 est fixé au boîtier 10 par l'intermédiaire d'un premier volume de colle 41. Le premier volume de colle 41 est positionné entre la première surface de liaison 55 et une surface conjuguée du boîtier 10. Il n'y a ainsi pas de contact direct entre la première surface de liaison 55 de l'organe de dissipation thermique 50 et le boîtier 10. L'épaisseur du premier volume de colle dépend des tolérances de fabrication du boîtier 10, de la puce 20 et de l'organe de dissipation thermique 50, ainsi que de leur assemblage. L'organe de dissipation thermique 50 est ainsi fixé au boîtier 10 selon un premier plan de liaison P1, sensiblement parallèle au plan P, défini par la première surface de liaison 55 et par l'épaisseur du premier volume de colle 41. Ainsi, le premier volume de colle 41 assure le maintien de l'organe de dissipation thermique par rapport au boîtier tout en remplissant une fonction de rattrapage de jeu entre ces deux composants.

De même, l'organe de dissipation thermique 50 est fixé à la carte électronique 30 par l'intermédiaire d'un deuxième volume de colle 42. Le deuxième volume de colle 42 est positionné entre la deuxième surface de liaison 56 et une surface conjuguée de la carte électronique 30. Cette surface conjuguée est positionnée sur une face de la carte électronique 30 opposée à la face de la carte électronique sur laquelle est fixée la puce 20. Il n'y a ainsi pas de contact direct entre la deuxième surface de liaison 56 et la carte électronique 30. L'épaisseur du deuxième volume de colle dépend des tolérances de fabrication de la carte électronique 30, de la puce 20 et de l'organe de dissipation thermique 50 ainsi que de leur assemblage. L'organe de dissipation thermique 50 est ainsi fixé à la carte électronique 30 selon un deuxième plan de liaison P2, sensiblement parallèle au plan P et au premier plan de liaison P1, défini par la deuxième surface de liaison 56 et par l'épaisseur du deuxième volume de colle 42. Le deuxième volume de colle 42 assure le maintien de la carte électronique 30 par rapport à l'organe de dissipation thermique 50 tout en remplissant une fonction de rattrapage de jeu entre ces deux composants.

Comme illustré sur la figure 3, l'organe de dissipation thermique et/ou le boîtier peuvent comprendre chacun une ouverture 43 destinée à laisser passer des rayons lumineux et débouchant dans le premier volume de colle 41. Cette ouverture 43 peut déboucher d'une part au centre de la première surface de liaison 55 et d'autre part sur une paroi extérieure du boîtier 10 et/ou de l'organe de dissipation thermique 50. L'ouverture 43 peut être orientée perpendiculairement à la première surface de liaison 55 et avoir une section circulaire. La première surface de liaison 55 a ainsi une forme annulaire autour de l'ouverture 43. Au cours du procédé d'assemblage du module optique 3, une lampe 44, apte à émettre un rayonnement UV (ultraviolet), peut être insérée dans l'ouverture 43 de manière à faire durcir le premier volume de colle 41. De la même manière, une deuxième ouverture similaire pourrait être aménagée pour déboucher au niveau du deuxième volume de colle.

Selon un deuxième mode de réalisation, illustré sur la figure 4, l'organe de dissipation thermique 50 est constitué de deux éléments distincts. D'une part il comprend un dissipateur thermique 51. D'autre part, il comprend un élément de liaison 57 fabriqué dans un matériau transparent ou translucide, comme par exemple un polymère transparent ou du verre. A l'instar du premier mode de réalisation, le dissipateur thermique 51 comprend une excroissance 52 passant au travers de l'ouverture 37 de la carte électronique 30. Cette excroissance 52 est en appui plan sur la deuxième face 23 de la puce 20. L'élément de liaison 57 comprend une première surface de liaison 55 et une deuxième surface de liaison 56 fixées respectivement au boîtier 10 et à la carte électronique 30 par l'intermédiaire d'un premier volume de colle 41 et d'un deuxième volume de colle 42.

L'élément de liaison 57 comprend une ouverture centrale 58 au travers de laquelle passe le dissipateur thermique 51. L'ouverture centrale 58 est délimitée par un bord intérieur 54 qui est en appui contre une collerette 59 du dissipateur thermique 51. L'élément de liaison 57 est sans contact avec le boîtier 10, et sans contact avec la carte électronique 30. La position du dissipateur thermique 51 est donc définie en référence à la puce 20. La position de l'élément de liaison 57 est définie en référence au dissipateur thermique 51. Les épaisseurs du premier et du deuxième volume de colle 41, 42 dépendent des tolérances de fabrication et d'assemblage des différents composants du module optique.

L'homme du métier pourra combiner les caractéristiques du premier mode de réalisation et du deuxième mode de réalisation. Notamment, l'utilisation d'un organe de dissipation thermique monobloc et transparent ou translucide pourrait être envisagée pour autant que le matériau choisi possède des caractéristiques de conduction thermique suffisante.

Dans les deux modes de réalisation décrits précédemment, la colle est avantageusement une colle apte à durcir sous l'effet d'un rayonnement lumineux, notamment une colle dite « UV », c'est-à-dire durcissant lorsqu'elle est exposée à un rayonnement ultraviolet. Avantageusement, le boîtier peut être fabriqué au moins localement à partir d'un matériau transparent ou translucide de manière à ce que les rayons ultraviolets puissent atteindre la colle. L'avantage d'une telle colle est d'atteindre un durcissement très rapide, ce qui évite le risque d'un déplacement relatif des composants du module optique avant le durcissement de la colle.

Une telle colle « UV » ne sera utilisée que si le volume de colle est accessible pour des rayons lumineux. En variante, la colle peut être une colle thermique c'est à dire une colle apte à durcir sous l'effet de la chaleur.

L'invention se rapporte également à un procédé de fabrication du module optique. Pour assembler un module optique muni d'un organe de dissipation thermique selon le premier mode de réalisation, on fixe la puce 20 comprenant la matrice de micro-miroirs 21 à la carte électronique 30, dans une première étape. Lors de cette étape, on peut notamment fixer, par exemple par soudure l'interface de connexion 24 à la carte électronique 30 puis enficher les broches 25 de la puce 20 dans les orifices de l'interface de connexion prévus à cet effet.

Ensuite, dans une deuxième étape, on positionne le boîtier du module optique en appui contre la puce. Notamment la surface de référence 25 est positionnée de sorte que les moyens de positionnement 27 coopèrent avec les plots 11 correspondant. A l'issue de cette étape, la puce 20 est positionnée directement en référence au boîtier 10 sans que les tolérances de fabrication ou d'assemblage du boîtier ou de la carte électronique 30 ne perturbent ce positionnement.

Dans une troisième étape, on applique un premier volume de colle 41 sur la première surface de liaison 55 de l'organe de dissipation thermique 50 ou sur la surface conjuguée du boîtier 10.

Dans une quatrième étape, on applique un deuxième volume de colle 42 sur la deuxième surface de liaison 56 de l'organe de dissipation thermique 50 ou sur la surface conjuguée de la carte électronique 30.

Ensuite, dans une cinquième étape, on positionne l'organe de dissipation thermique 50 en appui contre la puce 20, notamment de sorte que la surface d'échange 53 soit en contact plan contre la deuxième face 23 de la puce. On s'assure ainsi qu'un échange thermique optimal pourra avoir lieu par conduction entre la puce 20 et le dissipateur thermique 51. Le premier volume de colle 41 et le deuxième volume de colle 42, qui sont sous forme molle ou liquide, se déforment et occupent respectivement l'espace situé entre le boitier et la première surface de liaison et l'espace situé entre la carte électronique et la deuxième surface de liaison.

Ensuite, dans une sixième étape, on fait durcir le premier volume de colle 41 et le deuxième volume de colle 42. L'organe de dissipation thermique 50 peut être maintenu en position contre la puce 20 tant que la colle n'est pas durcie. Si la colle est une colle thermique, on positionne le module optique en cours de construction dans une étuve pour faire durcir la colle. Si la colle est une colle dite « UV », on expose le module optique à un rayonnement ultraviolet, ce qui permet d'obtenir un durcissement de la colle. Avantageusement, on insère la lampe 44, dite UV, dans l'ouverture 43 pour atteindre le premier volume de colle 41. On peut procéder de la même manière pour faire durcir le deuxième volume de colle 42. Ainsi les rayons ultraviolets font durcir la colle dans des zones qui seraient difficilement accessibles en absence d'ouverture. L'utilisation d'une colle « UV » permet d'obtenir un durcissement rapide de la colle sans recourir à l'utilisation d'une étuve.

Pour assembler un module optique muni d'un organe de dissipation thermique selon le deuxième mode de réalisation, le procédé d'assemblage est sensiblement identique. La cinquième étape peut être décomposée en deux sous-étapes. Lors d'une première sous-étape, on positionne le dissipateur thermique 51. Puis lors d'une deuxième sous-étape, on positionne l'élément de liaison 57 en appui contre le dissipateur thermique 51. Le bord intérieur 54 est mis en appui contre la collerette 59. Lors de la sixième étape, si la colle est une colle dite « UV », on expose l'élément de liaison à un rayonnement ultraviolet. Celui-ci étant transparent ou translucide, les rayons ultraviolets parviennent aisément aux premier et au deuxième volumes de colle, qui peuvent alors durcir.

Grâce à l'invention, la position relative de la carte électronique 30, dont la puce 20, de l'organe de dissipation thermique 50 et du boîtier 10 est obtenue avec précision sans exercer aucune contrainte néfaste sur la carte électronique 30 ou la puce 20. Ainsi, quelles que soient les tolérances de fabrication du boîtier 10, de la puce 20, de la carte électronique 30, de l'organe de dissipation thermique 50, ou de leur assemblage, on obtient à la fois un positionnement juste de la puce par rapport au boîtier, un contact plan entre la surface d'échange du dissipateur thermique et la puce, et une fixation adéquate de la carte électronique et de l'organe de dissipation thermique au boîtier.

La carte électronique 30 est ainsi fixée au boîtier sans contrainte. La fixation de la carte électronique ne risque pas de perturber le positionnement ou l'orientation de la puce 20. La carte électronique n'accumule aucune contrainte qui pourrait influencer le positionnement ou l'orientation de la puce 20 fixée à la carte électronique. De plus la carte électronique est protégée de l'extérieur par l'ensemble formé par le boîtier et l'organe de dissipation thermique, formant une coque enveloppant la carte électronique.

Lorsque la source lumineuse 4 émet un rayon lumineux R en direction d'un micro-miroir 21 en orientation active, le rayon lumineux est réfléchi avec précision vers le système optique de projection 5. L'image ainsi obtenue est correctement positionnée par rapport au boîtier. La puce 20 s'échauffe sous l'effet du rayonnement lumineux mais les calories ainsi produites sont dissipées efficacement par le dissipateur thermique. En effet, le contact plan de l'excroissance 52 contre la puce 20 permet un transfert thermique optimal de la puce vers le dissipateur thermique. Ainsi, la chaleur produite par la puce peut être efficacement évacuée par le dissipateur thermique.

Naturellement, l'invention ne se limite pas au mode de réalisation décrit. Notamment, l'organe de dissipation thermique pourrait revêtir toute autre forme adaptée à une fixation à une carte électronique et à un boîtier par l'intermédiaire de volumes de colle. De plus, la carte électronique peut comprendre tout autre composant que la puce 20 décrite, qui nécessite un bon positionnement relativement au boîtier.

Enfin, l'invention porte aussi sur un projecteur de véhicule automobile, intégrant au moins un tel module optique.

## Revendications

1. Module optique (3) **caractérisé en ce qu'**il comprend :
- un boîtier (10),
- une carte électronique (30),
- une puce (20) électronique comprenant une matrice de micro-miroirs (21), la puce (20) étant fixée à la carte électronique (30),
- un organe de dissipation thermique (50) comprenant un dissipateur thermique (51),
la puce (20) étant en contact d'une part contre le boîtier (10) et d'autre part avec le dissipateur thermique (51), l'organe de dissipation thermique (50) étant fixé au boîtier (10) par l'intermédiaire d'un premier volume de colle (41) et fixé à la carte électronique (30) par l'intermédiaire d'un deuxième volume de colle (42).

2. Module optique (3) selon la revendication précédente, **caractérisé en ce que** la carte électronique (30), l'organe de dissipation thermique (50) et le boîtier (10) sont sans contact direct entre eux.

3. Module optique (3) selon l'une des revendications précédentes, **caractérisé en ce que** la puce (20) comprend un moyen de positionnement (27) apte à coopérer avec le boîtier (10).

4. Module optique (3) selon l'une des revendications précédentes, **caractérisé en ce que** la puce (20) est fixée à la carte électronique (30) en vis-à-vis d'une ouverture (37) de la carte électronique (30), la puce (20) comprenant une première face (22) en contact avec le boîtier (10), la puce (20) comprenant une deuxième face (23) en contact avec le dissipateur thermique (51), la première face (22) et la deuxième face (23) étant deux faces opposées de la puce (20).

5. Module optique (3) selon l'une des revendications précédentes, **caractérisé en ce que** la carte électronique (30) s'étend selon un plan (P), **en ce que** l'organe de dissipation thermique (50) est fixé au boîtier (10) selon un premier plan de liaison (P1), et **en ce que** l'organe de dissipation thermique (50) est fixé à la carte électronique (30) selon un deuxième plan de liaison (P2), le premier plan de liaison (P1), le deuxième plan de liaison (P2) et le plan (P) dans lequel s'étend la carte électronique (30) étant sensiblement parallèles entre eux.

6. Module optique (3) selon l'une des revendications précédentes, **caractérisé en ce que** l'organe de dissipation thermique (50) est monobloc.

7. Module optique (3) selon l'une des revendications précédentes, **caractérisé en ce que** l'organe de dissipation thermique (50) et/ou le boîtier (10) et/ou la carte électronique (30) comprennent une ouverture (43) destinée à laisser passer des rayons lumineux, l'ouverture (43) débouchant dans le premier volume de colle (41) et/ou dans le deuxième volume de colle (42).

8. Module optique (3) selon l'une des revendications 1 à 5, **caractérisé en ce que** l'organe de dissipation thermique (50) comprend un élément de liaison (57) fabriqué dans un matériau transparent ou translucide lié au dissipateur thermique (51).

9. Module optique (3) selon l'une des revendications précédentes, **caractérisé en ce que** l'organe de dissipation thermique (50) comprend une surface d'échange (53) agencée sur une excroissance (52), en contact avec la puce (20), et une première surface de liaison (55) et une deuxième surface de liaison (56) agencées sur des saillies, fixées respectivement au boîtier (10) et à la carte électronique (30) par l'intermédiaire de respectivement les premier et deuxième volumes de colle, la surface d'échange et la première et la deuxième surfaces de liaison étant parallèles.

10. Module optique (3) selon l'une des revendications précédentes, **caractérisé en ce que** la colle est une colle thermique ou une colle apte à durcir sous l'effet d'un rayonnement lumineux, notamment UV.

11. Projecteur (2) **caractérisé en ce qu'**il comprend au moins un module optique (3) selon l'une des revendications précédentes.

12. Procédé de fabrication d'un module optique (3) **caractérisé en ce qu'**il comprend :
- une première étape de fixation d'une puce (20) comprenant une matrice de micro-miroirs (21) à une carte électronique (30),
- une deuxième étape de positionnement d'un boîtier (10) en appui contre la puce (20),
- une troisième étape d'application d'un premier volume de colle (41) sur une première surface de liaison (55) d'un organe de dissipation thermique (50) ou du boîtier (10),
- une quatrième étape d'application d'un deuxième volume de colle (42) sur une deuxième surface de liaison (56) de l'organe de dissipation thermique (50) ou de la carte électronique (30),
- une cinquième étape de positionnement d'un dissipateur thermique (51) de l'organe de dissipation thermique (50) en appui contre la puce (20), de la première surface de liaison (55) de l'organe de dissipation thermique (50) contre le boitier (10) par l'intermédiaire du premier volume de colle (41) et de la deuxième surface de liaison (56) de l'organe de dissipation thermique (50) contre la carte électronique (30) par l'intermédiaire du deuxième volume de colle (42),
- une sixième étape de durcissement du premier volume de colle (41) et du deuxième volume de colle (42).
